# EUROPEAN PATENT APPLICATION

(11) **EP 4 080 285 A1**
(43) Date of publication of application: **26.10.2022**
(21) Application number: 21169606.7
(22) Date of filing: 21.04.2021
(51) Int. Cl.: G03F 7/20, B24B 37/14, B24B 37/16, H01L 21/687

(54) **SURFACE TREATMENT DEVICE**

(71) Applicant: ASML Netherlands B.V., 5500 AH Veldhoven (NL)
(72) Inventor: AZIMI, Monim, 5500 AH Veldhoven (NL); DIJKSTRA, Michel, 5500 AH Veldhoven (NL); TROMP, Siegfried, Alexander, 5500 AH Veldhoven (NL)
(74) Representative: ASML Netherlands B.V.

(57) **Abstract**

A surface treatment device (30) for treating a surface (12) of a substrate support (10), wherein the surface treatment device comprises a contacting surface that is configured to contact the surface of the substrate support. The contacting surface is configured with at least a first contour (32) with a first centre of curvature and a second contour (34) with a second centre of curvature, wherein the first centre of curvature and the second centre of curvature are non-coincident points.

## Description

### FIELD

The present invention relates to a surface treatment device and a method of reconditioning a surface of a substrate support using the surface treatment device.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer). Transfer of the pattern is typically via imaging onto a layer of radiation-sensitive material (resist) provided on the substrate. In general, a single substrate will contain a network of adjacent target portions that are successively patterned. Conventional lithographic apparatus include so-called steppers, in which each target portion is irradiated by exposing an entire pattern onto the target portion at once, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

Integrated circuits and other microscale devices are often manufactured using optical lithography, but other manufacturing techniques, such as imprint lithography, e-beam lithography and nano-scale self-assembly are known. Generally, a substrate will be supported by a substrate holder whilst the substrate is provided with the desired pattern. When the substrate is positioned on the substrate holder, friction between the substrate and the substrate holder may prevent the substrate from flattening out over a surface of the substrate holder. To address this issue, the substrate holder can be provided with support elements which minimize the contact area between the substrate and the substrate holder. The support elements on the surface of the substrate holder may otherwise be referred to as burls or protrusions. The support elements are generally regularly spaced (e.g., in a uniform array) and of uniform height and define a very flat overall support surface on which the substrate can be positioned. The support elements reduce the contact area between the substrate holder and the substrate, thus reducing friction, and allowing the substrate to move to a flatter position on the substrate holder.

The support elements generally extend substantially perpendicularly from a surface of the substrate holder in a first direction. In operation, the backside of the substrate is supported on the support elements, at a small distance from the main body surface of the substrate holder. Thus, the tops of the support elements (i.e., support surfaces), rather than the main body surface of the substrate holder, define an effective support surface for the substrate.

In order to avoid overlay errors during, for example, projection of a patterned beam of radiation on a substrate, it is desirable that the substrate top surface be flat. Unevenness of the supporting surfaces of the substrate support may lead to an uneven top surface of the substrate. Therefore, it is desirable to avoid unevenness in the substrate support.

The flatness of the substrate can be reduced if there is contamination between the top surfaces of the support elements and the substrate. Wear of the support elements may also lead to unevenness.

A substrate supports are typically periodically cleaned by moving a treatment tool (or treatment device) over the top surfaces of the support elements (in directions orthogonal to the first direction), thereby to remove contamination from the substrate support. Such treatment tools are disclosed in WO 2016/081951 and WO 2018/224303. The treatment tool may be rotated at the same time as it is moved over the substrate support. For example the treatment tool may be arranged such that a surface, which contacts the top surfaces of the support elements, rotates in a plane parallel to the plane in which the top surfaces of the support elements lie. The footprint of the treatment tool is typically smaller than that of the substrate support so that the substrate support and treatment tool are moved relative to one another during the treatment. The treatment tool may be made, for example, of granite or Si/SiC.

The treatment tools may also be configured to modify the distal ends of the support elements. That is, by applying these tools to interact with the substrate support, the surface roughness of the distal ends is changed and hereby the substrate support is reconditioned. These treatment tools are typically circular in shape and have a flat and continuous contacting surface area, as is disclosed in WO 2019/154630, or have a contacting surface formed by a plurality of protrusions, as is disclosed in WO 2020/020568. Another known treatment tool is provided with a contacting surface having a toroidal shape, herewith making closed-loop line contact with the surface to be treated, WO 2016/081951.

Known treatment devices introduce a non-equal material removal (reconditioning) of the substrate support at the edge region and at the centre region. This means that treatment devices are lacking in repairing the centre region and or the edge region of the substrate support. A non-optimally reconditioned substrate support may eventually lead to overlay errors during production.

It is an object of the invention to provide a surface treatment device that enables improved reconditioning of an component surface, e.g., a surface of an substrate support at the edge region and the centre region.

### SUMMARY

According to an aspect of the invention there is provided a surface treatment device for treating a surface of a substrate support. The surface treatment device comprises a contacting surface that is configured to contact the surface of the substrate support. The contacting surface has at least a first contour with a first centre of curvature and a second contour with a second centre of curvature, wherein the first centre of curvature and the second centre of curvature are non-coincident points. This enables a reduction of contacting surface, for example, while the first contour has a radius substantially equal to an outer radius of the substrate support, which is beneficial for the reconditioning performance of the surface treatment device. Especially, reconditioning of the surface of an substrate support at the edge region and the centre region is improved.

According to another aspect of the invention, the surface treatment device is configured with the second contour having a second radius substantially equal to the first radius. Next to the reduced contacting area, the second contour may be used to align with the periphery of the substrate support, similar as the first contour.

According to a further aspect of the invention, the surface treatment device may comprise a recessed region at the contacting surface. Herewith, the surface load by the surface treatment device to the substrate support (or workpiece) may be optimized. Hence, this may result in an improved reconditioning performance of the device.

Further, by providing a chamfered edge at the contacting surface of the surface treatment device a more gradual transition can be obtained when the surface treatment device passes over an uneven surface during a reconditioning action.

According another aspect of the invention, the surface treatment device may be a modular surface treatment device comprising a carrier element, a bonding layer, and a surface treatment sheet. The bonding layer is arranged to bond the surface treatment sheet to the carrier element, and the surface treatment sheet comprising the contacting surface. Herewith, the surface treatment sheet can be replaced by a different sheet, for example, when the surface treatment sheet is worn or when a sheet with different surface properties is required for the reconditioning action.

According another aspect of the invention, the surface treatment device has a contacting surface comprising at least one of granite, silicon, silicon carbide, diamond-like carbon, and diamond. The choice of material may depend on the material properties of the surface that needs to be treated (reconditioned).

According another aspect of the invention, the contacting surface comprises a first surface area and a second surface area, with the first and second surface area having different contacting surface characteristics. Based on the area ratio between the first and second surface area, the effective load provided by the surface treatment device towards the workpiece (or substrate support) can be optimized. The area ratio may also beneficial to tune and optimize the reconditioning performance of the surface treatment device.

According another aspect of the invention, the surface treatment device may comprise protrusions at the contacting surface. These protrusions may be provided at the first and or second surface area.

According to an aspect of the invention, there is provided a method for reconditioning a support surface of a substrate support using a surface treatment device. The method comprises:
(a) aligning a first contour of a first surface treatment device with a periphery of the substrate support;
(b) bringing the first surface treatment device in contact with the support surface;
(c) moving the first surface treatment device and the substrate support relative to each other while the first surface treatment device is in contact with the support surface; and
(d) maintaining the alignment between the first contour and the periphery of the substrate support during the relative movement.

### BRIEF DESCRIPTION OF THE DRAWINGS

Embodiments of the invention will now be described, by way of example only, with reference to the accompanying schematic drawings, in which:
- Figure 1A depicts a schematic plan view of a conventional surface treatment device on a substrate support;
- Figure 1B depicts a schematic cross-sectional view of a conventional surface treatment device on a substrate support;
- Figure 1C illustrates the reconditioning performance of a conventional surface treatment device as a function of position on the substrate support.
- Figure 2 depicts a schematic plan view of a surface treatment device, according to an embodiment of the invention, on a substrate support;
- Figure 3A, 3B, and 3C depict schematic views of a surface treatment device, according to an embodiment of the invention, on a substrate support at three positions.
- Figure 4A, 4B, 4C, and 4D depict schematic views of surface treatment devices, according to embodiments of the invention.
- Figure 5A, 5B, and 5C depict schematic views of surface treatment devices, according to embodiments of the invention.
- Figure 6 depicts a schematic bottom view of a surface treatment device, according to an embodiment of the invention, with close-up views of a contacting surface.
- Figure 7 depicts a schematic cross-sectional view of a surface treatment device, according to an embodiment of the invention.
- Figure 8A depicts a schematic plan view of a surface treatment system, according to an embodiment of the invention.
- Figure 8B depicts schematic cross-sectional views of the surface treatment system, as depicted in Figure 8A, during a reconditioning process of a substrate support
- Figure 9A depicts a schematic plan view of a surface treatment system, according to an embodiment of the invention.
- Figure 9B depicts schematic cross-sectional views of the surface treatment system, as depicted in Figure 9A, during a reconditioning process of a substrate support.

### DETAILED DESCRIPTION

During a lithographic process, a substrate, which is disposed on a substrate support, is exposed to an image projected onto the surface of the substrate by an exposure system located within a lithography system. The lithographic apparatus may be of a type wherein at least a portion of the substrate may be covered by a liquid having a relatively high refractive index, e.g., water, so as to fill a space between the projection system and the substrate, which is also referred to as immersion lithography. More information on immersion techniques is given in US6952253, which is incorporated herein by reference.

The lithographic apparatus may also be of a type having two or more substrate supports (also named "dual stage"). In such "multiple stage" machine, the substrate supports may be used in parallel, and/or steps in preparation of a subsequent exposure of the substrate may be carried out on the substrate located on one of the substrate support while another substrate on the other substrate support is being used for exposing a pattern on the other substrate.

Substrate supports, e.g., wafer tables, are workpieces consisting of a body material, which is typically provided with a plurality of protrusions, also called burls. The primary function of the substrate support and the burls is to support a substrate. Typically, the top surfaces of the burls are configured with a nano-roughness to minimize the impact of friction between the substrate and the burls, which is beneficial for overlay performance when used in a lithographic apparatus. During use, the substrate support may be exposed to fluids, e.g., rinsing and or immersion liquids, and interacts with the backside of the substrates loaded onto the substrate support. Herewith, the nano-roughness on top of the burls is slowly smoothed away with every wafer load and unload, and diminishing the lifetime of the substrate support dramatically.

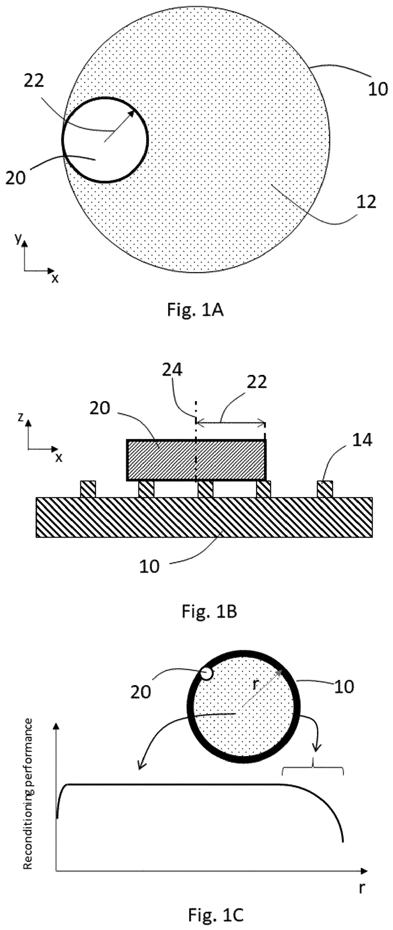

As the surface of the substrate support degrades over time, the surface may be reconditioned (or treated) by means of a reconditioning device in order to extend the lifetime of the substrate support. Figures 1A and 1B depict illustrations of a substrate support 10 constructed to hold a substrate at a support surface 12. The substrate support comprises a plurality of protrusions 14 (e.g., burls) to support the substrate. A conventional surface treatment device 20 is arranged to interact with the top surfaces of the plurality of protrusions 14 in order to recondition the top surfaces. The conventional surface treatment device 20 is typically circular or ring-shaped having a contour with a radius 22 smaller than the radius of the substrate support 10.

During typical reconditioning procedures, the surface treatment device 20 is in contact with the support surface 12 of the substrate support 10, while moving relatively to each other in a substantially planar motion (in the xy-plane). This may be an orbital motion in the plane defined by the substrate support. At the edge region, the device 20 follows the edge contour of the substrate support 10. Generally, the conventional surface treatment device 20 does not go beyond the edge (or rim) of the substrate support 10 during the reconditioning procedure, as this may result in a change of contacting pressure between the conventional surface treatment device 20 and the substrate support 10. In turn, this may result in an uncontrolled reconditioning of the support surface 12 at the edge region.

With the relative movement of the conventional surface treatment device 20 and the substrate support surface 12 with respect to each other, the conventional surface treatment device 20 may follow a trajectory limited by the periphery of the substrate support 10 over the surface. For example, the trajectory may be along the periphery of the substrate support 10. The inventors noticed that due to the shape the conventional surface treatment device 20 and its relative motion, the contacting time of the conventional surface treatment device 20 with edge burls (or burls at the edge region), which are distributed in a ring with a width of approximately the radius 22 of the conventional surface treatment device 20 at the periphery, is less than the contacting time of the device 20 with burls further away from the edge of the substrate support 10. This means that the reconditioning performance of the conventional surface treatment device 20 for burls arranged within a distance of less than the radius 22 of the conventional surface treatment device 20 from the outer edge of the substrate support 10 - as illustrated by the dark ring in the inset of Figure 1C - is less than for those burls further away from the edge. Hence, the reconditioning performance of the conventional surface treatment device 20 is not constant over the surface of the workpiece that is being reconditioned. At the edge of the substrate support 10, as well as at centre area, the reconditioning performance drops as illustrated by Figure 1C.

The inventors recognized that the shape of the conventional surface treatment device 20 is a limiting factor for the performance of the conventional surface treatment device 20. To recondition the support surface 12 at the periphery, the surface treatment device should have a contour that matches with the outer contour of the substrate support 10. This would mean that the conventional surface treatment device 20 would be similar in size as the substrate support 10, which is not a preferred solution.

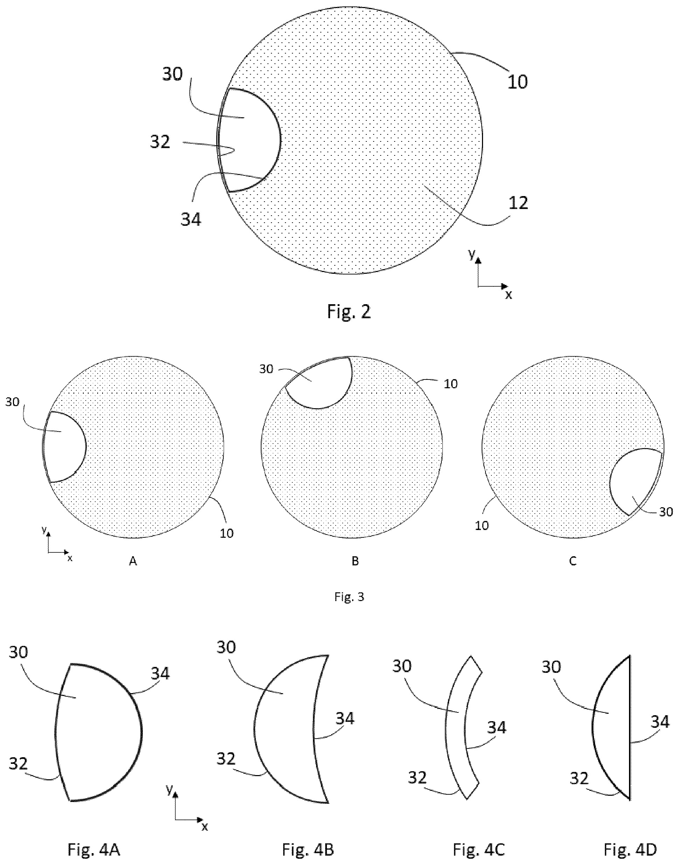

Figure 2 depicts an illustration of an embodiment of a surface treatment device 30 according to the invention. The surface treatment device 30 comprises a contacting surface, which is configured to contact a surface of a workpiece, e.g., a support surface 12 of a substrate support 10, in order to recondition the support surface 12. The contacting surface comprises at least a first contour 32 and a second contour 34 with a first centre of curvature 33 and a second centre of curvature 35, respectively. Wherein, the first centre of curvature 33 and the second centre of curvature 35 are non-coincident points.

A conventional surface treatment device 20 is typically circularly shaped having a single contour and a single centre of curvature, or annularly shaped having an outer and an inner contour defined by a single and joint centre of curvature.

In order to improve the reconditioning performance of the surface treatment device 30 with respect to conventional surface treatment devices 20, at least the first contour 32 may have a first curvature that is substantially similar as the curvature of the periphery at the surface of the substrate support 10 to be reconditioned by the surface treatment device 30. Hence, the first contour 32 has a radius substantially equal to an outer radius of the substrate support 10.

For example, a surface treatment device 30 arranged to recondition a surface of a substrate support 10 with an outer diameter of 300 mm, thus with an outer radius of 150 mm, comprises a first contour 32 corresponding to a radius of 150 mm. Herewith, the surface treatment device 30 enables reconditioning of the support surface 12 at the periphery.

As illustrated by Figure 2, the surface treatment device 30 has an overlapping area portion with the workpiece that is smaller than the area covered by the surface of the workpiece, e.g., the substrate support. Hence, the area directly covered by the surface treatment device 30 is a segment of the area of the workpiece surface.

The second contour 34 is arranged at the opposite side of the surface treatment device 30 with respect to the first contour 32. By means of the second contour 34, the area of the contacting surface of the surface treatment device 30 can be defined. This is beneficial for reducing the contacting time of the surface treatment device 30 with the burls 14 that are arranged a bit further from the edge of the substrate support 10. Thus, the support surface 12 at the edge region of the substrate support 10 can be reconditioned with no or limited impact to the support surface 12 distant from the edge region, allowing a uniform reconditioning performance over the whole surface, including the centre region.

To ensure optimal reconditioning of the support surface 12, the orientation of the surface treatment device 30 needs to be adapted to the location at the support surface 12. That is, the surface treatment device 30 is arranged to rotate as it (relatively) moves along the periphery of the substrate support 10 such that the first contour 32 remains aligned with the periphery of the substrate support 10, as is illustrated in Figure 3. Hence, the rotation of the surface treatment device 30 is synchronized with the relative movement of the substrate support 10 and or the location of the surface treatment device 30 at the surface 12 of the substrate support 10. Note, the relative movement is a movement of the surface treatment device and the substrate support relative to each other.

Synchronization of the surface treatment device 30 with the workpiece, e.g., the substrate support, may be done by means of a controller. The controller may receive information of the surface treatment device 30, for example, information of position and orientation of the surface treatment device 30 with respect to the substrate support 10, and may receive information of the substrate support 10, for example, information of position and velocity of the substrate support 10 with respect to the surface treatment device 30. Based on the received information, the controller, which may comprise a control software to calculate and to define a relative position and orientation of the surface treatment device 30, may be arranged to provide a control signal to the surface treatment device 30 and the substrate support 10. Herewith, controlling the surface treatment device 30 and/or the substrate support 10 during a reconditioning process. The controller may be part of a lithographic apparatus, for example, when the surface treatment device is arranged in the lithographic apparatus.

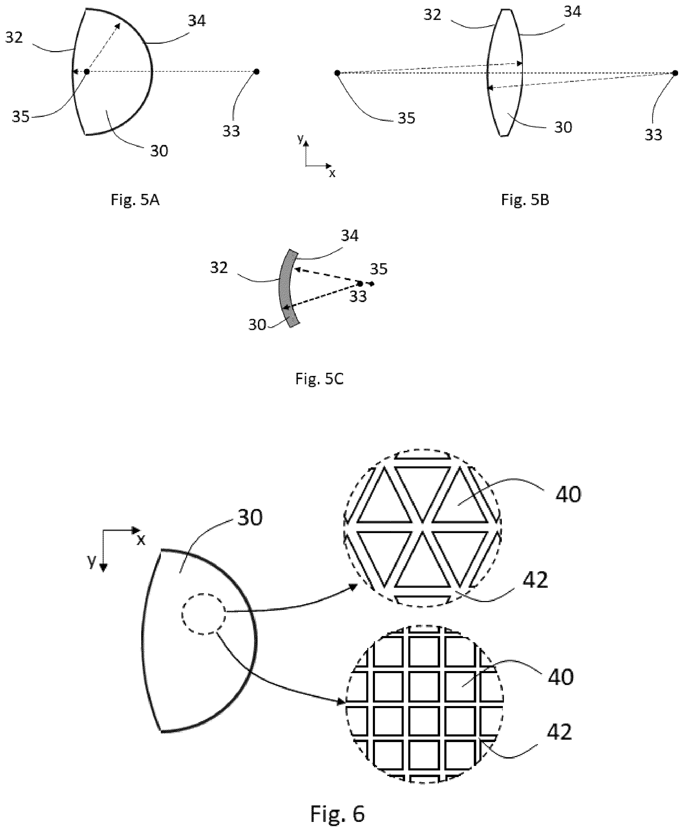

Figures 4A to 4D as well as Figures 5A to 5C illustrate surface treatment devices 30 according to the invention. As explained above, the first contour 32 with the first centre of curvature 33 will be substantially similar as the curvature of the periphery at the surface of the substrate support 10. To keep the surface treatment device 30 relatively small with respect to the substrate support, the actual size and contacting area of the device 30 is limited by the second contour 34. Otherwise, the surface treatment device would have substantially the same dimension as the workpiece, which would not be practical when the device is arranged and used, for example, in a lithographic apparatus.

Second contour 34 having a second centre of curvature 35, with the second centre of curvature 35 and the first centre of curvature 33 being non-coincident points, may be a convex contour (as illustrated in Figure 4A, 5A, 5B), a concave contour (as illustrated in Figure 4B, 4C, 5C), or a flat contour (as illustrated in Figure 4D). Second contour 34 may have the same radius as the radius of the first contour, as illustrated in Figure 5B. Herewith, the second contour 34 can be used to align with the periphery of the substrate support 10.

According to an embodiment of the invention, the surface treatment device 30 may be formed as a single piece having a continuous contacting surface. The continuous contacting surface, being a substantially flat surface, may be beneficial for flattening and/or cleaning the surface of the support surface 12. Such a flattening or cleaning device may be used to remove contamination at the support surface 12. With the surface treatment device 30 according the invention, contamination removal can be done locally, as well as over the whole surface. Thus, allowing local and global reconditioning of the support surface 12, including the centre region.

According to another embodiment of the invention, the surface treatment device 30 comprises a contacting surface having protrusions. Figure 6 illustrates a surface treatment device 30 and close-ups of the contacting surface comprising protrusions 40. The protrusions 40 may have, for example, a triangular shape or a square shape, as illustrated. The shape of the protrusions 40 are not limited to the illustrated shapes, but may be of any shape. A gap, or a groove, 42 may be provided between adjacent protrusions 40. The grooves 42 may collect the debris that is removed from the support surface 12, especially from the burls 14, during the reconditioning process. In addition, with an arrangement of the protrusions 40 and grooves 42, the nominal contacting area of the surface treatment device 30 with the support surface 12 is reduced, and hereby the effective contacting pressure by the protrusions at the support surface 12 can be increased. This may affect the reconditioning performance.

In another embodiment, the surface treatment device 30 may have a contacting surface comprising a first surface area and a second surface area, wherein the first and second surface area have different contacting surface characteristics. For example, the first surface area may comprise a continuous contacting surface and the second surface area may comprise a contacting surface having protrusions. Or, for example, both the first and the second surface area may comprise protrusions, each with a different protrusion area density and or protrusion shape. Based on the area ratio between the first and second surface area, the effective load provided by the surface treatment device towards the workpiece can be optimized. The area ratio may also beneficial to tune and optimize the reconditioning performance of the surface treatment device 30. The difference in surface characteristics may also be a difference in material (composition), hardness, and or roughness.

Fluid supply ports and fluid extraction ports may be arranged at an interior part of the surface treatment device 30 and or at an outer part of the surface treatment device (at outer edge). Herewith, a fluid supporting the reconditioning action may be provided and or debris that is generated by the recondition action may be extracted and removed. The fluid ports may be (external) supply ports and extraction ports.

In another embodiment, the surface treatment device 30 may comprise thermal conditioning means. These thermal means may be cooling lines and or heating lines embedded in the surface treatment device 30. Herewith, the surface treatment device 30 may be kept at a defined or preferred working temperature. It may be advantageous to cool or to heat the surface treatment device 30 with respect to its environment for enhanced reconditioning performance. That is, removal of debris may not be optimal at the temperature of the apparatus, e.g., clean room temperature, but an increased (or lowered) temperature may result in an increased efficiency of the reconditioning action.

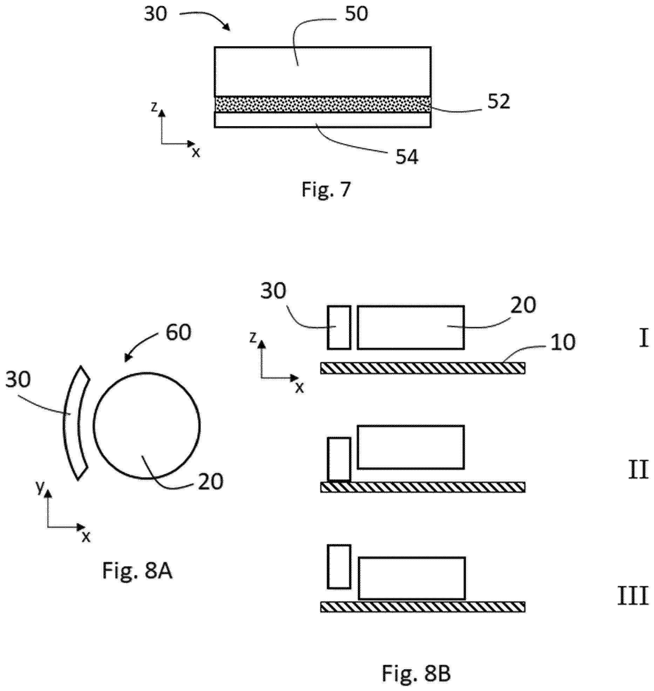

Figure 7 depicts an illustration, cross-sectional view, of a surface treatment device 30 according an embodiment of the invention. The surface treatment device 30 can be a modular device comprising a carrier element 50, a bonding layer 52, and a surface treatment sheet 54, wherein the bonding layer is arranged to bond the surface treatment sheet 54 to the carrier element 50. The surface treatment sheet 54 has a contacting surface to recondition a surface of a workpiece, e.g., the support surface 12, and a bonding surface is provided at the opposite side, such that the surface treatment sheet 54 can be bonded to the carrier element 50 by means of the bonding layer 52.

According to the invention, the surface treatment sheet 54 has a contacting surface comprising at least a first contour 32 with a first centre of curvature 33 and a second contour 34 with a second centre of curvature 35, wherein the first centre of curvature 33 and the second centre 35 of curvature are non-coincident points. The carrier element 50 and the bonding layer 52 may have the same shape as the surface treatment sheet 54, in order to have optimal functionality regarding surface pressure control between the surface treatment device 30 and the workpiece as well as working volume.

The skilled person may appreciate that the pressure uniformity is improved by the introduction of the bounding layer 52. That is, the bonding layer 52 reduces the stiffness of the surface treatment device. Hence, the reduced stiffness results in less variation of the pressure over the contact area.

The bonding layer 52 may be an adhesive layer. The bonding layer 52 may comprise touch fasteners, including hook-and-loop and hook-and-pile fasteners.

The surface treatment sheet 54 may be a removable sheet. Herewith the surface treatment sheet 54 can be removed from the carrier element 50 and replaced by a new surface treatment sheet 54. For example, when the contacting surface is worn and when the reconditioning performance of the sheet 54 decreases, replacement of the surface treatment sheet is preferred. The surface treatment sheet 54 may also be replaced with a sheet having different surface properties that are required for a specific reconditioning action. Hence, the carrier element 54 of the modular surface treatment device can be kept in place (or installed), while the reconditioning surface (contacting surface of the surface treatment device) is replaced.

The surface treatment sheet 54 may comprise a plurality of protrusions and or grooves similar as the contacting surface of the surface treatment device 30 as illustrated in Figure 6.

Figure 8A depicts an illustration, top-view, of a surface treatment system 60 according to an embodiment of the invention. The surface treatment system 60 comprises a conventional surface treatment device 20 and a surface treatment device 30 according to the embodiments of the invention. For example, the surface treatment system 60 comprises a surface treatment device 30 as illustrated in Figures 4 and 5, but not limited to these exemplary embodiments. The surface treatment system is configured to accommodate and to control a recondition procedure with one or more (conventional) surface treatment devices.

In the arrangement, as depicted by Figure 8A, the surface treatment device 30 is arranged to recondition a surface of a substrate support 10 (a workpiece) at the periphery region and the conventional surface treatment device 20 is arranged to recondition the remainder of the surface.

The surface treatment system as illustrated in Figure 8A, is depicted in a cross-sectional view in Figure 8B. The surface treatment system is illustrated in three situations:
I: retracted mode - both the conventional surface treatment device 20 and the surface treatment device 30 are positioned in an upward position. In this situation, none of the devices are in contact with the surface of the substrate support 10. Hence, no reconditioning of the support surface is performed.
II: edge mode - the conventional surface treatment device 20 is in an upward position and the surface treatment device 30 is in a reconditioning position and placed in contact with the surface of the substrate support 10. Especially, the surface treatment device 30 is positioned and in contact with the edge (or periphery) region of the support surface.
III: centre mode - the conventional surface treatment device 20 is in a reconditioning position and placed in contact with the surface of the substrate support 10 and the surface treatment device 30 is in an upward position. During this mode, the centre region of the support surface is reconditioned by the conventional surface treatment device 20.

Reconditioning of a support surface 12 of a substrate support 10 can be performed by means of a reconditioning method making use of the surface treatment system 60 as illustrated by Figures 8A and 8B. In an implementation of the reconditioning method according the invention, the substrate support 10 is provided and positioned underneath the surface treatment system 60. The surface treatment device 30 brought in contact with the support surface 12 in a contact area at the edge region of the support surface 12, with the first contour 32 aligned with the periphery of the substrate support 10. Bringing the surface treatment device 30 in contact with the support surface 12 may be done by lowering the device 30. For example, the surface treatment system 60 is set (configurated) in the edge mode (II) as illustrated in Figure 8B. The surface treatment device 30 and the substrate support 10 move relative to each other while the surface treatment device 30 is in contact with the support surface 12. The relative movement may comprise a rotational motion, either by the substrate support 12 or the substrate treatment device 30, to maintain the alignment between the first contour 32 and the periphery. After reconditioning (a portion of) the edge region of the support surface 12, the surface treatment device 30 is repositioned or retracted, e.g., placed in an upward position, such that the contacting surface is not in contact with the support surface 12. The conventional surface treatment device 20 may be brought in contact with the support surface 12 in a contact area outside the edge region of the support surface 12. Thus, the conventional surface treatment device 20 is brought contact with the area that is not yet reconditioned by the surface treatment device 30. For example, the surface treatment system 60 is set (configurated) in the centre mode (III) as illustrated in Figure 8B. A relative motion between the conventional surface treatment device 20 and the support surface 12 is initiated while the device 20 is in contact with the support surface 12. The relative motion may be an orbital motion. After reconditioning of the support surface 12, the conventional surface treatment device 20 is repositioned or retracted, e.g., placed in an upward position, such that the conventional surface treatment device 20 is not in contact with the support surface 12. For example, the surface treatment system 60 is set (configurated) in the retracted mode (I) as illustrated in Figure 8B.

The order of the operating modes during the reconditioning process is not limited to the order as disclosed above. For reconditioning a support surface 12, the reconditioning process may start with the conventional surface treatment device 20 followed by the surface treatment device 30.

The skilled person will appreciate that the whole support surface 12 may be reconditioned by means of the surface treatment device 30 of the surface treatment system 60.

Both the conventional surface treatment device 20 and the surface treatment device 30 may contact the support surface 12 at the same moment (simultaneously), in order to recondition the support surface 12.

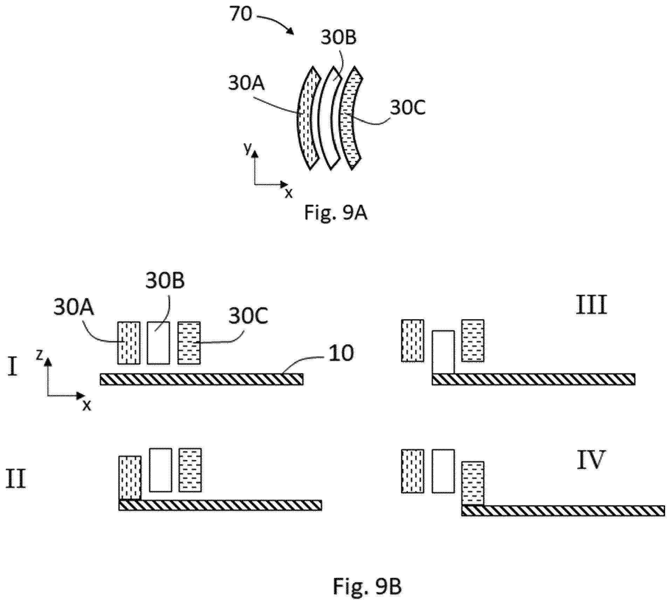

Figure 9A depicts an illustration, top-view, of a surface treatment system 70 according to another embodiment of the invention. The surface treatment system 70 comprises a plurality of surface treatment devices 30 according to an embodiment of the invention, as disclosed above. The plurality of surface treatment devices 30 may be arranged in a group. The surface treatment system 70 may comprise, for example, a first surface treatment device 30A, a second surface treatment device 30B, and a third surface treatment device 30C. In this arrangement, each of the plurality of surface treatment devices 30A, 30B, 30C are arranged to recondition a surface of a workpiece, e.g., a substrate support 10.

Although Figure 9A depicts a surface treatment system 70 with surface treatment devices 30A, 30B, 30C of the same shape and same size, the surface treatment system 70 may comprise a plurality of surface treatment devices 30 having different shapes and different sizes. The shape of the individual device 30A, 30B, 30C may be similar in shape as the surface treatment devices 30 illustrated in Figures 4 and 5, but the shape is not limited to these examples.

Reconditioning of a support surface 12 of a substrate support 10 can be performed by means of a reconditioning method making use of the surface treatment system 70 as illustrated by Figures 9A and 9B. In an implementation of the reconditioning method according the invention, the substrate support 10 is provided and positioned underneath the surface treatment system 70. This can be referred as a retracted mode (I), wherein all surface treatment devices 30A, 30B, 30C are in a upward position with respect to the substrate support 10. A first surface treatment device 30A is brought in contact with the support surface 12 in a contact area at the edge region of the support surface 12, with a first contour of the first surface treatment device 30A aligned with the periphery of the substrate support 10. Bringing the first surface treatment device 30A in contact with the support surface 12 may be done by lowering the first device 30A. For example, the surface treatment system 70 is in a first mode (II) as illustrated in Figure 9B. The first surface treatment device 30A and the substrate support 10 move relative to each other while the first surface treatment device 30A is in contact with the support surface 12. The relative movement may comprise a rotational motion, either by the substrate support 12 or the first substrate treatment device 30A, to maintain the alignment between the first contour of the first surface treatment device 30A and the periphery. The alignment is maintained by a synchronized rotation of the surface treatment device 30A in respect to the orientation (or contour) of the periphery. After reconditioning (a portion of) the edge region of the support surface 12, the first surface treatment device 30A is repositioned or retracted, e.g., placed in an upward position, such that the contacting surface of the first surface treatment device 30A is not in contact with the support surface 12. The reconditioning process may be followed by similar recondition action performed by a second surface treatment device 30B and in addition by a third surface treatment device 30C. For these next steps, the first contours of the second and the third surface treatment devices 30B, 30C are aligned with the periphery of the substrate support 10, as illustrated by a second mode (III) and third mode (IV) of Figure 9B, respectively. Reconditioning of the support surface 12 by means of the second and third surface treatment devices 30B, 30C may be similar as described for the first surface treatment device 30A.

A surface reconditioning method according to the invention may involve a series of surface reconditioning steps. The reconditioning method may be directed to reconditioning of an edge region of a support surface 12. The series of steps may comprise reconditioning of the edge region with a first surface treatment device 30A followed by a reconditioning of the edge region with a second surface treatment device 30B. In addition, reconditioning of the edge region may be continued with a third surface treatment device 30C.

The plurality of surface treatment devices 30 (30A, 30B, 30C) of the surface treatment system 70, may be used separately (individual reconditioning action) or combined. That is, two or more surface treatment devices 30A, 30B, 30C may be used at the same time.

Each surface treatment device 30A, 30B, 30C arranged in the surface treatment system 70 may have a dedicated reconditioning function. That is, the reconditioning function (or reconditioning characteristics) of each surface treatment device 30A, 30B, 30C may differ between each other. The difference may be governed by the material (composition), material hardness, contacting surface flatness and roughness, as well as the presence of protrusions. For example, the first surface treatment device 30A may be used for cleaning a surface, the second surface treatment device 30B may be used for roughening the surface, and the third surface treatment device 30C may be used for flattening the surface.

The plurality of surface treatment devices 30A, 30B, 30C may be used in combination with a conventional surface treatment device 20, similar as disclosed above in reference to Figure 8A and 8B. Thus, the surface treatment devices 30A, 30B, 30C may be used to recondition an edge region of a support surface 12, whereas the conventional surface treatment device 20 may be used to recondition the remaining part of the support surface 12 (centre portion).

The contacting surface of the surface treatment device 30 may be 5 mm to 50 mm in size, as measured in the plane of contact of the device with the workpiece. Preferably, the surface treatment device 30 has a length in the range of 25 mm to 35 mm and a width in the range of 10 mm to 30 mm For example, the surface treatment device 30 has a length of 30 mm and a width of 15 mm.

The material of the surface treatment device 30 that is arranged to be in contact with the workpiece, e.g., the substrate support 10, may be a material at least as hard or harder than the material of the workpiece that needs to be reconditioned. Since substrate supports are typically made from a hard material such as ceramic (e.g., silicon carbide (SiC) or a material having SiC grains in a silicon matrix (Si/SiC)), the surface treatment device 30, as well as the conventional surface treatment device 20 when using the system 60 as illustrated by Figure 8A, should be at least as hard. This hardness is desired to enable reconditioning of the support surface 12. The surface treatment device 30 may comprise granite, silicon, silicon nitride, silicon carbide, diamond-like carbon (DLC), or diamond. For example, a granite-based device may be used to clean a support surface 12 of the substrate support 10. An silicon carbide (e.g., an Si/SiC composition) based device may, for example, be used to remove an oxidation layer at the support surface 12, in order to flatten the support surface 12. A surface treatment device 30 comprising diamond, for example comprising diamond grains, may be suitable for roughening the upper surface of the burls 14 at the support surface 12. Herewith, scratches are made at the upper surface. This results in a roughened upper surface and herewith improving the interaction between a substrate and the substrate support 12, when the substrate is provided at the substrate support 10.

According to a further embodiment of the invention, the surface treatment device 30 may comprise a recessed area at the contacting surface. This recess area is arranged not to contact the workpiece. Herewith, the effective contacting area of the surface treatment device 30 is reduced, which may be beneficial during a reconditioning action of burls at the edge region of a substrate support 10 as the burls located further away from the edge are not reconditioned by the device 30 during this recondition action.

Furthermore, the surface treatment device 30 may have a chamfered edge. The chamfer provides a gradual transition as the surface treatment device 30 passes over an uneven surface during a reconditioning action.

A structure, which may be a holder, may be configured to hold the one or more surface treatment devices 30. Attachment means may be arranged to attach the surface treatment device 30 to the structure. The attachment means may be a clamp configuration, in order to clamp and hold the surface treatment device 30. The structure may comprise a release mechanism that allows replacement of the surface treatment device 30.

A drive system may be arranged and configured to move the surface treatment device 30 while the contacting surface of the device 30 is in contact with the support surface 12 of the substrate support. The drive system may be arranged to move the surface treatment device 30 in a planar motion with respect to the support surface 12. The drive system may be arranged to rotate the surface treatment device 30 substantially in the plane of the support surface 12. Herewith, synchronizing the orientation of the surface treatment device 30, especially the first contour 32, with the periphery of the substrate support 10.

The surface treatment device 30 as well as the surface treatment system 60, 70, according to the invention may be used in a lithographic apparatus to recondition a substrate support in-situ, and in a stand-alone apparatus used to refurbish or to recondition substrate supports.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of lithography, it will be appreciated that the invention, where the context allows, is not limited to optical lithography and may be used in imprint lithography or other applications.

Aspects of the invention are set out in the clauses below.
1. A surface treatment device for treating a surface of a substrate support, said surface treatment device comprising a contacting surface configured to contact the surface of the substrate support, said contacting surface having at least a first contour with a first centre of curvature and a second contour with a second centre of curvature, wherein the first centre of curvature and the second centre of curvature are non-coincident points.
2. The surface treatment device according to clause 1, wherein the first contour has a first radius substantially equal to an outer radius of the substrate support.
3. The surface treatment device according to clause 2, wherein the second contour has a second radius substantially equal to the first radius.
4. The surface treatment device according to any one of clauses 1 to 3, wherein the contacting surface has a recessed region.
5. The surface treatment device according to any one of clauses 1 to 4, wherein the contacting surface has a chamfered edge.
6. The surface treatments device according to any one of clauses 1 to 3, being a modular surface treatment device comprising a carrier element, a bonding layer, and a surface treatment sheet, wherein the bonding layer is arranged to bond the surface treatment sheet to the carrier element, and the surface treatment sheet comprises the contacting surface.
7. The surface treatment device according to any of clauses 1 to 6, further comprising at least one of granite, silicon, silicon nitride, silicon carbide, diamond-like carbon, and diamond.
8. The surface treatment device according to any of preceding clauses, wherein the contacting surface comprises protrusions.
9. The surface treatment device according to any of preceding clauses, wherein the contacting surface comprises a first surface area and a second surface area, with the first and second surface area having different contacting surface characteristics.
10. The surface treatment device according to any of preceding clauses, further comprising thermal conditioning means.
11. A surface treatment system comprising one or more surface treatment devices according to any of preceding clauses.
12. The surface treatment system according to clause 11, having a first surface treatment device and a second surface treatment device, wherein the first and second surface treatment devices differ in at least one of material composition, material hardness, an contacting surface roughness.
13. A lithographic apparatus comprising one or more surface treatment devices according to any of preceding clauses.
14. The lithographic apparatus according to clause 13, further comprising a controller arranged to synchronize an orientation of the one or more surface treatment devices with a periphery of the substrate support.
15. A method for reconditioning a support surface of a substrate support using a surface treatment device, comprising:
   (a) aligning a first contour of a first surface treatment device with a periphery of the substrate support;
   (b) bringing the first surface treatment device in contact with the support surface;
   (c) moving the first surface treatment device and the substrate support relative to each other while the first surface treatment device is in contact with the support surface; and
   (d) maintaining the alignment between the first contour and the periphery of the substrate support during the relative movement.
16. The method according to clause 15, further comprising: repeating the steps (a) to (d) using a second surface treatment device.
17. The method according to clause 15 or 16, wherein the alignment is maintained by a synchronized rotation of the surface treatment device with the periphery of the substrate support.
18. The surface treatment device according to any of clauses 1 to 5, comprising a material at least as hard or harder than the material of the surface of the substrate support.
19. The surface treatment device according to clause 9, wherein the difference in contacting surface characteristics is a difference in at least one of material, hardness, and roughness.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A surface treatment device for treating a surface of a substrate support, said surface treatment device comprising a contacting surface configured to contact the surface of the substrate support, said contacting surface having at least a first contour with a first centre of curvature and a second contour with a second centre of curvature, wherein the first centre of curvature and the second centre of curvature are non-coincident points.

2. The surface treatment device according to claim 1, wherein the first contour has a first radius substantially equal to an outer radius of the substrate support.

3. The surface treatment device according to claim 2, wherein the second contour has a second radius substantially equal to the first radius.

4. The surface treatment device according to any one of claims 1 to 3, wherein the contacting surface has a recessed region.

5. The surface treatment device according to any one of claims 1 to 4, wherein the contacting surface has a chamfered edge.

6. The surface treatments device according to any one of claims 1 to 3, being a modular surface treatment device comprising a carrier element, a bonding layer, and a surface treatment sheet, wherein the bonding layer is arranged to bond the surface treatment sheet to the carrier element, and the surface treatment sheet comprises the contacting surface.

7. The surface treatment device according to any of claims 1 to 6, further comprising at least one of granite, silicon, silicon carbide, silicon nitride, diamond-like carbon, and diamond.

8. The surface treatment device according to any of preceding claims, wherein the contacting surface comprises protrusions.

9. A surface treatment system comprising one or more surface treatment devices according to any of preceding claims.

10. The surface treatment system according to claim 9, having a first surface treatment device and a second surface treatment device, wherein the first and second surface treatment devices differ in at least one of material composition, material hardness, an contacting surface roughness.

11. A lithographic apparatus comprising one or more surface treatment devices according to any of preceding claims.

12. The lithographic apparatus according to claim 11, further comprising a controller arranged to synchronize an orientation of the one or more surface treatment devices with a periphery of the substrate support.

13. A method for reconditioning a support surface of a substrate support using a surface treatment device, comprising:
(a) aligning a first contour of a first surface treatment device with a periphery of the substrate support;
(b) bringing the first surface treatment device in contact with the support surface;
(c) moving the first surface treatment device and the substrate support relative to each other while the first surface treatment device is in contact with the support surface; and
(d) maintaining the alignment between the first contour and the periphery of the substrate support during the relative movement.

14. The method according to claim 13, further comprising:
repeating the steps (a) to (d) using a second surface treatment device.

15. The method according to claim 13 or 14, wherein the alignment is maintained by a synchronized rotation of the surface treatment device with the periphery of the substrate support.
